# EUROPÄISCHE PATENTSCHRIFT

(11) **EP 2 595 461 B1**
(45) Veröffentlichungstag und Bekanntmachung des Hinweises auf die Patenterteilung: **13.08.2014**
(21) Anmeldenummer: 11189400.2
(22) Anmeldetag: 16.11.2011
(51) Int. Cl.: H01R 12/51, H01R 13/6587, H05K 3/30, H05K 3/32, H01R 13/6594

(54) **Anordnung mit einer Leiterplatte und mit einem Anschlusselement**
Assembly with a circuit board and a connection element
Agencement doté d'une plaquette et d'un élément de connexion

(43) Veröffentlichungstag der Anmeldung: 22.05.2013
(73) Patentinhaber: Siemens Aktiengesellschaft, 80333 München (DE)
(72) Erfinder: Bräunlich, Michael, 09117 Chemnitz (DE); Griessbach, Gunter, 09423 Gelenau (DE); Kuhn, Michael, 09119 Chemnitz (DE); Rochlitzer, Daniela, 09114 Chemnitz (DE); Schmidt, Dirk, 08321 Zschorlau/OT Albernau (DE)

(56) Entgegenhaltungen:
- US-A- 4 533 191
- US-A1- 2005 003 685
- US-A1- 2010 062 618

## Beschreibung

Die Erfindung betrifft eine Anordnung mit einer Leiterplatte und mit einem Anschlusselement, welches mehrere Anschlüsse zum Anschließen von Signalleitungen aufweist. Darüber hinaus betrifft die Erfindung ein Anschlusselement für eine derartige Anordnung.

Aus dem Siemens-Katalog ST 70, Kapitel 9, Ausgabe 2011 ist ein Automatisierungsgerät in Form einer so genannten "Dezentralen Peripherie" bekannt, welche für eine dezentrale Automatisierung eines zu steuernden technischen Prozesses vorgesehen ist. Diese Peripherie ist über einen geeigneten Bus mit einem übergeordneten Automatisierungsgerät bzw. Automatisierungssystem verbunden und weist Automatisierungskomponenten in Form von mit Elektronikmodulen bestückten Basismodulen auf, die mit Anschlusselementen zum Anschließen von Kommunikations- und Prozesssignalleitungen versehen sind. Die Prozesssignalleitungen eines Signalkabels sind zur Übermittlung von Prozesssignalen vorgesehen, z. B. Prozesssignale in Form von Sensor- und/oder Aktorsignalen, wobei ein Sensor, z. B. ein Druck- oder Temperatursensor, dem Elektronikmodul der Automatisierungskomponente ein Sensorsignal zuführt, welches eine erfasste Temperatur oder einen erfassten Druck repräsentiert, und das Elektronikmodul beispielsweise nach der Verarbeitung des Sensorsignals mittels eines Aktorsignals einen Aktor ansteuert.

Über die Kommunikationsleitungen eines Kommunikationskabels kommuniziert die Automatisierungskomponente mit einer weiteren Automatisierungskomponente oder einem weiteren Automatisierungsgerät, d. h., über diese Leitungen tauschen die verbundenen Komponenten und Geräte geeignete Informationen aus. Gewöhnlich sind diese an ein Anschlusselement angeschlossenen Kommunikationsleitungen bzw. das Kommunikationskabel mittels einer mit Schirmpotential versehenen metallischen Hülle abgeschirmt, um den Einfluss elektromagnetischer Störfelder, insbesondere elektromagnetische Störfelder in einer rauen Prozessumgebung, zu verringern. Diese Störfelder können sich schädlich auf die Kommunikationssignale auswirken, beispielsweise in Form einer störenden Signalbeeinflussung. Allerdings können über diese metallische Hülle bzw. Abschirmung hochfrequente Ströme fließen, die sich ebenfalls nachteilig auswirken; denn diese erzeugen ein magnetisches Störfeld, welches beispielsweise die Prozesssignale von benachbarten Prozesssignalleitungen störend beeinflusst.

Es sind daher Maßnahmen erforderlich, welche ein Einkoppeln der genannten Störungen in die Automatisierungskomponente sowie ein Auskoppeln von Störungen bzw. Störaussendungen durch die Automatisierungskomponente z. B. an benachbarte Automatisierungskomponenten weitgehend verhindern, wobei sichergestellt sein muss, dass auch das Anschlusselement den Anforderungen im Hinblick auf Störfestigkeit sowie Störaussendungen genügt. Dadurch wird weitgehend ein fehlerfreies und sichereres Steuern eines technischen Prozesses gewährleistet, d. h., es wird weitgehend sichergestellt, dass die Automatisierungskomponente bzw. das Automatisierungsgerät einen technischen Prozess zur Lösung der Automatisierungsaufgabe fehlerfrei steuern kann.

Eine Anordnung gemäß dem Oberbegriff des Anspruchs 1 ist aus der US 2010/0062618 A1 bekannt.

Der Erfindung liegt daher die Aufgabe zugrunde, eine Anordnung der eingangs genannten Art mit einem verbesserten Verhalten im Hinblick auf die elektromagnetische Verträglichkeit (EMV-Verhalten) und darüber hinaus ein Anschlusselement für eine derartige Anordnung mit einem verbesserten EMV-Verhalten zu schaffen.

Diese Aufgabe wird im Hinblick auf die Anordnung durch die im kennzeichnenden Teil des Anspruchs 1, bezüglich des Anschlusselements durch die im kennzeichnenden Teil des Anspruchs 4 angegebenen Maßnahmen gelöst.

Vorteilhaft ist, dass durch die besondere Gestaltung des Anschlusselementes bezüglich seiner Abschirmmittel in Verbindung mit der geschirmten Außenlage der Leiterplatte einerseits die Störfestigkeit verbessert und andererseits die Störaussendung - auch im Rahmen einer hochfrequenten Signalübertragung - vermindert wird. Das besonders gestaltete Anschlusselement ist mechanisch stabil und für einen Industrieeinsatz besonders geeignet. Darüber hinaus sind durch den schwenkbar ausgebildeten Deckel eines Teils des Abschirmmittels die Anschlüsse des Anschlusselementes für einen Service-Techniker leicht zugänglich.

Die an ein Schirmpotential angeschlossene Außenlage der Leiterplatte und die Gestaltung des Anschlusselementes bewirken, dass ein hochfrequenter über den Kabelschirm und über das Anschlusselement fließender Störstrom zur Außenlage der Leiterplatte abgeleitet wird. Dieser Störstrom erzeugt ein Störmagnetfeld, wobei es mittels der besonderen Ausgestaltung des Abschirmmittels im Inneren des Anschlusselementes weitgehend nicht zur Induktion von durch das Störmagnetfeld verursachten Störspannungen in den Signalleitungen kommen kann. Zur Ableitung des Störstroms werden gezielt Strompfade "erzwungen", die bezüglich der Signalleitungen symmetrisch angeordnet sind. Durch diese symmetrische Ausgestaltung der Abschirmmittel wird das Magnetfeld, das die benachbarten Strompfade umgibt, im Bereich der Signalleitungen nahezu kompensiert, was bedeutet, dass die Signale nur unwesentlich beeinflusst werden. Darüber hinaus können die elektrischen und magnetischen Felder, die von diesen Strömen und/oder den Potentialen der Signalleitungen verursacht werden, nicht nach außen dringen und benachbarte elektronische Komponenten störend beeinflussen; auch hier kommt es zum oben beschriebenen Kompensationseffekt.

Durch ein Anschlusselement mit einem derartig gestalteten Abschirmelement wird eine sichere Übertragung hochfrequenter bzw. schneller Signale ermöglicht, wobei im Unterschied zu bekannten Anschlusselementen für Automatisierungskomponenten ein verbessertes Qualitätsniveau, verbesserte Performanceeigenschaften und eine höhere Systemstabilität bzw. Robustheit verwirklicht werden.

In einer Ausgestaltung der Erfindung ist vorgesehen, dass die Seitenteile des ersten und zweiten Teils des Abschirmmittels mit jeweils mehreren Stiften, z. B. mit jeweils drei, mit der Außenlage der Leiterplatte kontaktieren, wodurch mit einfachen Maßnahmen symmetrische Ableitwege für Störströme geschaffen werden.

Weitere vorteilhafte Ausgestaltungen ergeben sich aus den weiteren Unteransprüchen.

Anhand der Zeichnung, in der ein Ausführungsbeispiel der Erfindung veranschaulicht ist, werden im Folgenden die Erfindung, deren Ausgestaltungen sowie Vorteile näher erläutert.

Es zeigen:
- Figur 1: eine Anordnung mit einer Leiterplatte und einem Anschlusselement,
- Figur 2: Abschirmmittel eines Anschlusselements und
- Figur 3: eine Schnittdarstellung des Abschirmmittels gemäß Figur 2.

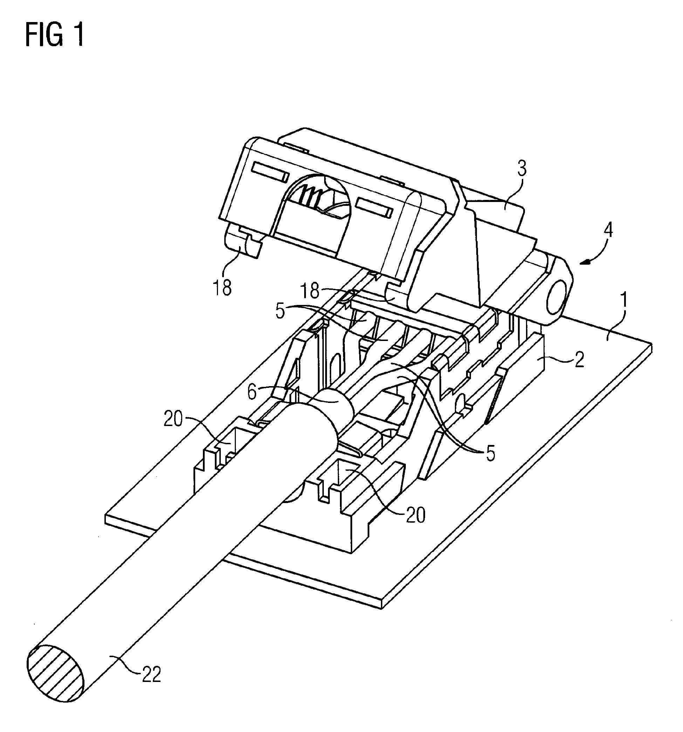

Die in den Figuren 1 bis 3 dargestellten gleichen Teile sind mit gleichen Bezugszeichen versehen.

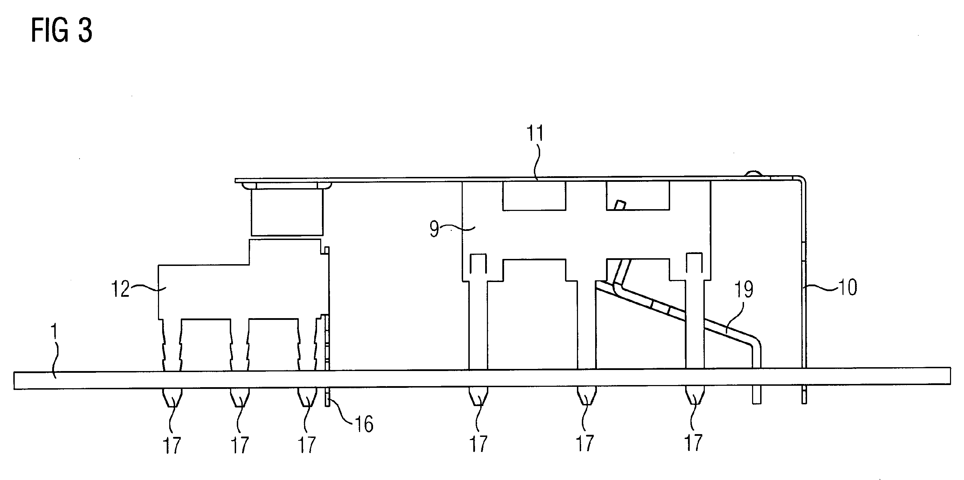

In Figur 1 ist mit 1 eine Leiterplatte, beispielsweise eine Mehrlagen-Leiterplatte, einer Automatisierungskomponente bezeichnet, deren Außenlage an ein Schirmpotential, z. B. eine Funktionserde, angeschlossen ist. Auf dieser Leiterplatte 1 ist ein mit einem Unter- und einem Oberteil 2, 3 versehenes Anschlusselement 4 angeordnet, welches zum Anschluss von Kommunikationsleitungen 5 eines Kommunikationskabels vorgesehen ist, wobei die Kommunikationsleitungen 5 von einem Kabelschirm 6 des Kommunikationskabels 22 umhüllt sind. Das Unterteil 2 des Anschlusselementes 4 ist auf der Mehrlagen-Leiterplatte 1 befestigt und weist Leiterführungen 19 (Figur 3) zum Verbinden der Kommunikationsleitungen 5 mit entsprechenden Kontaktstellen der Mehrlagen-Leiterplatte 1 auf. Das Oberteil 3 ist an der Rückseite des Unterteils 2 schwenkbar gelagert, wobei an der der Rückseite gegenüberliegenden Seite des Anschlusselementes 4 das Kommunikationskabel 22 in das Anschlusselement 4 eingeführt ist.

Im vorliegenden Beispiel sind die Kommunikationsleitungen 5 mittels Schneidklemmen angeschlossen. Selbstverständlich können auch andere Anschlussarten vorgesehen sein, z. B. können die Kommunikationsleitungen 5 mittels Schraub- oder Federzugverbindung angeschlossen werden. Für den Fall, dass das Oberteil 3 geschlossen wird, wobei dazu das Oberteil 3 mit dem Unterteil 2 mittels einer Verriegelung 18, 20 mit dem Unterteil 2 verriegelt, verbessert ein zweiteiliges metallisches Abschirmmittel des Anschlusselementes 4 in Verbindung mit der geschirmten Außenlage der Mehrlagen-Leiterplatte 1 einerseits die Störfestigkeit der Automatisierungskomponente und vermindert andererseits die Störaussendung durch diese Automatisierungskomponente.

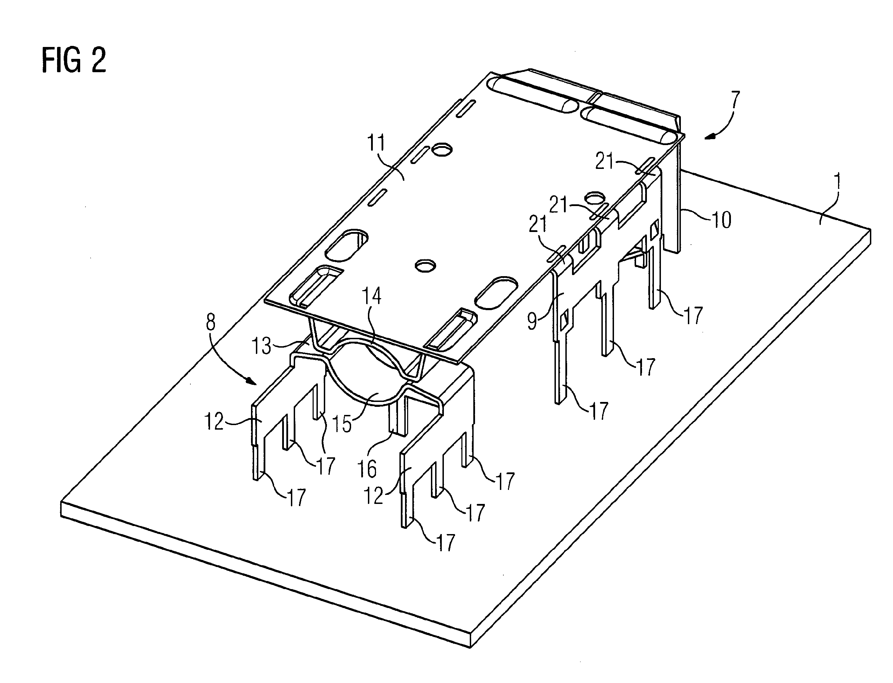

Ein derartiges zweiteiliges Abschirmmittel ist in den Figuren 2 und 3 dargestellt. Dieses weist zwei Abschirmteile 7, 8 auf, von denen ein Abschirmteil 7 versehen ist mit zwei symmetrisch ausgebildeten Seitenteilen 9, mit einer mit der Außenlage der Mehrlagen-Leiterplatte 1 kontaktierenden Rückwand 10 sowie mit einem relativ zur Rückwand 10 schwenkbaren Deckel 11. Die Seitenteile 9 und die Rückwand 10 weisen federnde Auflagen 21 auf, wodurch für den Fall, dass das Oberteil 3 mit dem Unterteil 2 verriegelt (Figur 1), der Deckel 11 mit den Seitenteilen 9 federnd kontaktiert. Das andere Abschirmteil 8 des zweiteiligen Abschirmmittels weist ebenfalls zwei symmetrisch ausgebildete Seitenteile 12 auf, die über einen Steg 13 miteinander verbunden sind. An der der Rückwand 10 gegenüberliegenden Seite ist eine hohlzylinderförmige, aus zwei Halbschalen 14, 15 gebildete Schirmauflage vorgesehen, wobei der Deckel 11 mit der Halbschale 14 und der Steg 13 mit der Halbschale 15 versehen ist. Sowohl die Halbschale 15 als auch die Seitenteile 9, 12 kontaktieren über Lötstifte bzw. Einpressstifte 16, 17 mit der Außenlage der Mehrlagen-Leiterplatte 1, wobei der Stift 16 mittig an der Halbschale 15 angeordnet ist und diese elektrisch mit der Außenlage verbindet. Für den Fall, dass das Oberteil 3 mit dem Unterteil 2 (Figur 1) verriegelt ist, kontaktieren die Halbschalen 14 und 15 durch einen direkten Kontakt miteinander und/oder durch den eingelegten Kabelschirm 6.

Die Gestaltung bzw. der symmetrische Aufbau des metallischen, zwei Teile 7, 8 umfassenden Abschirmmittels und die geschirmte Außenlage der Mehrlagen-Leiterplatte 1 bilden einen "Käfig" um die Signalleitungen. Die Schirmauflage des Kabels ist flächig ausgeführt und bewirkt gleichzeitig über die Halbschale 14 dieser Schirmauflage eine Verbindung zum Deckel 11. Durch die beidseitige mehrfache Verbindung der Schirmauflage mittels der Stifte 17 zur Schirmfläche - zur Außenlage der Mehrlagen-Leiterplatte 1 - wird eine gute Ableitung erzielt und die magnetischen Störfelder werden kompensiert. Der Stift 16 kontaktiert mit der Außenlage der Mehrlagen-Leiterplatte 1, wobei mittels dieses Stiftes 16 ein mittiger Schirmanschluss an der Rückseite der Schirmauflage bzw. der Halbschale 15 dieser Schirmauflage bewirkt wird und sich kein elektrisches Feld aufbauen kann. Der im Wesentlichen rechteckig ausgebildete Deckel 11, die jeweils an drei Stellen mittels der Stifte 17 mit der Außenlage der Mehrlagen-Leiterplatte 1 verbundenen Seitenteile 9, 12, die geschlossene, im Wesentlichen rechteckig ausgebildete Rückwand 10 mit ebenfalls mehrfacher Kontaktierung mit der Außenlage der Mehrlagen-Leiterplatte 1 vervollständigen die Schirmwirkung.

Ein auf dem Kabel fließender Störstrom wird mit niedriger Impedanz zur Schirmlage der Mehrlagen-Leiterplatte 1 abgeleitet. Dieser Störstrom teilt sich im Wesentlichen symmetrisch auf die beiden Seitenteile 9 des Abschirmteils 7 und auf die beiden Seitenteile 12 des Abschirmteils 8 auf und es entstehen in den Ableitwegen im Wesentlichen gleich große Störmagnetfelder. In axialer Richtung der Signalleitungen eliminieren sich im Wesentlichen diese Felder, wodurch Störeinkopplungen in diese Signalleitungen minimiert werden, was bedeutet, dass eine sehr gute Störfestigkeit erreicht wird. Auch eine mögliche Störaussendung aufgrund schneller Schaltflanken der Signale bzw. aufgrund der durch die Signalleitungen fließenden hochfrequenten Ströme wird durch das netzartige metallische Abschirmmittel bzw. Abschirmsystem weitgehend minimiert.

## Patentansprüche

1. Anordnung mit einer Leiterplatte (1) und mit einem auf der Leiterplatte (1) angeordneten Anschlusselement (4), welches mehrere Anschlüsse zum Anschließen von Signalleitungen (5) aufweist, wobei das Anschlusselement (4) ein zwei Abschirmteile (7, 8) umfassendes Abschirmmittel aufweist, **dadurch gekennzeichnet, dass**
- die Leiterplatte (1) eine Außenlage zur Abschirmung aufweist,
- eines dieser Abschirmteile (7) des Abschirmmittels zwei symmetrisch ausgebildete Seitenteile (9), eine im Wesentlichen rechteckförmig ausgebildete Rückwand (10) und einen relativ zur Rückwand (10) schwenkbaren, im Wesentlichen rechteckförmig ausgebildeten Deckel (11) aufweist, wobei die Seitenteile (9) und die Rückwand (10) mit der Außenlage der Leiterplatte (1) kontaktieren und der Deckel (11) mit einer (14) von zwei Halbschalen (14, 15) einer hohlzylinderförmigen Schirmauflage versehen ist, welche der Rückseite (10) gegenüberliegend angeordnet ist,
- das andere Abschirmteil (8) des Abschirmmittels zwei symmetrisch ausgebildete Seitenteile (12) und einen die Seitenteile (12) verbindenden Steg (13) aufweist, welcher mit der anderen Halbschale (15) der Schirmauflage versehen ist, wobei diese andere Halbschale (15) mittig über einen Stift (16) und die Seitenteile (12) mit der Außenlage der Leiterplatte (1) kontaktieren.

2. Anordnung nach Anspruch 1, **dadurch gekennzeichnet, dass** die Seitenteile (9, 12) des ersten und zweiten Teils (7, 8) des Abschirmmittels mit jeweils mehreren Stiften (17) mit der Außenlage der Leiterplatte (1) kontaktieren.

3. Anordnung nach Anspruch 1 oder 2, **dadurch gekennzeichnet, dass** die Seitenteile (9) und die Rückwand (10) federnd kontaktierbare Auflagen (21) aufweisen.

4. Anschlusselement für eine Anordnung nach Anspruch 1 bis 3, wobei das Anschlusselement (4) ein zwei Abschirmteile (7, 8) umfassendes Abschirmmittel aufweist, **dadurch gekennzeichnet, dass**
- eines dieser Abschirmteile (7) des Abschirmmittels zwei symmetrisch ausgebildete Seitenteile (9), eine im Wesentlichen rechteckförmig ausgebildete Rückwand (10) und einen relativ zur Rückwand (10) schwenkbaren, im Wesentlichen rechteckförmig ausgebildeten Deckel (11) aufweist, wobei die Seitenteile (9) und die Rückwand (10) dazu ausgebildet sind, mit einer Außenlage einer Leiterplatte (1) zu kontaktieren, und der Deckel (11) mit einer (14) von zwei Halbschalen (14, 15) einer hohlzylinderförmigen Schirmauflage versehen ist, welche der Rückseite (10) gegenüberliegend angeordnet ist,
- das andere Abschirmteil (8) des Abschirmmittels zwei symmetrisch ausgebildete Seitenteile (12) und einen die Seitenteile (12) verbindenden Steg (13) aufweist, welcher mit der anderen Halbschale (15) der Schirmauflage versehen ist, wobei diese andere Halbschale (15) mittig über einen Stift (16) zum Kontaktieren mit der Außenlage der Leiterplatte (1) versehen ist und wobei die Seitenteile (12) dazu ausgebildet sind, mit der Außenlage der Leiterplatte (1) zu kontaktieren.

5. Anschlusselement nach Anspruch 4, **dadurch gekennzeichnet, dass** die Seitenteile (9, 12) des ersten und zweiten Teils (7, 8) des Abschirmmittels mit jeweils mehreren Stiften (17) zum Kontaktieren mit der Außenlage der Leiterplatte (1) versehen sind.

6. Anschlusselement nach Anspruch 4 oder 5, **dadurch gekennzeichnet, dass** die Seitenteile (9) und die Rückwand (10) federnd kontaktierbare Auflagen (21) aufweisen.

## Claims

1. Arrangement comprising a printed circuit board (1) and comprising a connection element (4) which is arranged on the printed circuit board (1) and has a plurality of connections for connecting signal lines (5), wherein the connection element (4) has a shielding means which comprises two shielding parts (7, 8), **characterized in that**
- the printed circuit board (1) has an outer layer for shielding purposes,
- one of these shielding parts (7) of the shielding means has two side parts (9) which are of symmetrical design, a rear wall (10) which is of substantially rectangular design, and a cover (11) which can be pivoted relative to the rear wall (10) and is of substantially rectangular design, wherein the side parts (9) and the rear wall (10) make contact with the outer layer of the printed circuit board (1) and the cover (11) is provided with one (14) of two half-shells (14, 15) of a hollow-cylindrical shield support which is arranged opposite the rear face (10),
- the other shielding part (8) of the shielding means has two side parts (12) which are of symmetrical design and a web (13) which connects the side parts (12) and is provided with the other half-shell (15) of the shield support, wherein this other half-shell (15), centrally by means of a pin (16), and the side parts (12) make contact with the outer layer of the printed circuit board (1).

2. Arrangement according to Claim 1, **characterized in that** the side parts (9, 12) of the first and the second part (7, 8) of the shielding means, by way of in each case several pins (17), make contact with the outer layer of the printed circuit board (1).

3. Arrangement according to Claim 1 or 2, **characterized in that** the side parts (9) and the rear wall (10) have supports (21) with which contact can be made in a sprung manner.

4. Connection element for an arrangement according to Claims 1 to 3, wherein the connection element (4) has a shielding means which comprises two shielding parts (7, 8), **characterized in that**
- one of these shielding parts (7) of the shielding means has two side parts (9) which are of symmetrical design, a rear wall (10) which is of substantially rectangular design, and a cover (11) which can be pivoted relative to the rear wall (10) and is of substantially rectangular design, wherein the side parts (9) and the rear wall (10) are designed to make contact with an outer layer of a printed circuit board (1), and the cover (11) is provided with one (14) of two half-shells (14, 15) of a hollow-cylindrical shield support which is arranged opposite the rear face (10),
- the other shielding part (8) of the shielding means has two side parts (12) which are of symmetrical design and a web (13) which connects the side parts (12) and is provided with the other half-shell (15) of the shield support, wherein this other half-shell (15), centrally by means of a pin (16), is provided for making contact with the outer layer of the printed circuit board (1), and wherein the side parts (12) are designed to make contact with the outer layer of the printed circuit board (1).

5. Connection element according to Claim 4, **characterized in that** the side parts (9, 12) of the first and the second part (7, 8) of the shielding means are provided with in each case several pins (17) for making contact with the outer layer of the printed circuit board (1).

6. Connection element according to Claim 4 or 5, **characterized in that** the side parts (9) and the rear wall (10) have supports (21) with which contact can be made in a sprung manner.

## Revendications

1. Agencement comprenant une plaquette ( 1 ) à circuit imprimé et un élément ( 4 ) de connexion, qui est monté sur la plaquette ( 1 ) à circuit imprimé et qui a plusieurs bornes pour la connexion de lignes ( 5 ) de signal, l'élément ( 4 ) de connexion ayant un moyen de blindage comprenant deux parties ( 7, 8 ) de blindage, **caractérisé en ce que**
- la plaquette ( 1 ) à circuit imprimé a une couche extérieure pour le blindage,
- l'une des parties ( 7 ) de blindage du moyen de blindage a deux parties ( 9 ) latérales constituées symétriquement, un fond de panier ( 10 ) sensiblement de forme rectangulaire et un couvercle ( 11 ) pivotant par rapport au fond de panier ( 10 ) et de forme sensiblement rectangulaire, les parties ( 9 ) latérales et le fond de panier ( 10 ) étant en contact avec la couche extérieure de la plaquette ( 1 ) à circuit imprimé et le couvercle ( 11 ) étant pourvu de l'une ( 14 ) de deux hémicoquilles ( 14, 15 ) d'un appui de blindage en forme de cylindre creux, qui est disposé à l'opposé du côté ( 10 ) arrière,
- l'autre partie ( 8 ) de blindage du moyen de blindage a deux parties ( 12 ) latérales constituées symétriquement et une âme ( 13 ) qui relie les parties ( 12 ) latérales et qui est pourvue de l'autre hémicoquille ( 15 ) de l'appui de blindage, cette autre hémicoquille ( 15 ) étant au milieu, par une broche ( 16 ) et les parties ( 12 ) latérales, en contact avec la couche extérieure de la plaquette ( 1 ) à circuit imprimé.

2. Agencement suivant la revendication 1, **caractérisé en ce que** les parties ( 9, 12 ) latérales de la première et de la deuxième parties ( 7, 8 ) du moyen de blindage sont en contact par, respectivement, plusieurs broches ( 17 ) avec la couche extérieure de la plaquette ( 1 ) à circuit imprimé.

3. Agencement suivant l'une des revendications 1 ou 2, **caractérisé en ce que** les parties ( 9 ) latérales et le fond de panier ( 10 ) ont des appuis ( 21 ) pouvant être mis en contact élastiquement.

4. Elément de connexion pour un agencement suivant la revendication 1 à 3, dans lequel l'élément ( 4 ) de connexion a un moyen de blindage comprenant deux parties ( 7, 8 ) de blindage, **caractérisé en ce que**
- l'une de ces parties ( 7 ) de blindage du moyen de blindage a deux parties ( 9 ) latérales constituées symétriquement, un fond de panier ( 10 ) de forme sensiblement rectangulaire et un couvercle ( 11 ) pivotant par rapport au fond de panier ( 10 ) et de forme sensiblement rectangulaire, les parties ( 9 ) latérales et la paroi ( 10 ) arrière étant constituées pour venir en contact avec une couche extérieure d'une plaquette ( 1 ) à circuit imprimé et le couvercle ( 11 ) étant pourvu de l'une ( 14 ) de deux hémicoquilles ( 14, 15 ) d'un appui de blindage, qui est en forme de cylindre creux et qui est disposé à l'opposé du fond de panier ( 10 ),
- l'autre partie ( 8 ) de blindage du moyen de blindage a deux parties ( 12 ) latérales constituées symétriquement et une âme ( 13 ) qui relie les parties ( 12 ) latérales et qui est pourvue de l'autre hémicoquille ( 15 ) de l'appui de blindage, cette autre hémicoquille ( 15 ) étant pourvue au milieu d'une broche ( 16 ) de mise en contact avec la couche extérieure de la plaquette ( 1 ) à circuit imprimé et les parties ( 12 ) latérales étant constituées pour venir en contact avec la couche extérieure de la plaquette ( 1 ) à circuit imprimé.

5. Elément de connexion suivant la revendication 4, **caractérisé en ce que** les parties ( 9, 12 ) de la première et de la deuxième parties ( 7, 8 ) du moyen de blindage sont pourvues de, respectivement, plusieurs broches ( 17 ) pour la mise en contact avec la couche extérieure de la plaquette ( 1 ) à circuit imprimé.

6. Elément de connexion suivant la revendication 4 ou 5, **caractérisé en ce que** les parties ( 9 ) latérales et le fond de panier ( 10 ) ont des appuis ( 21 ) pouvant être mise en contact élastiquement.
